# EUROPEAN PATENT SPECIFICATION

(11) **EP 0 502 210 B1**
(45) Date of publication and mention of the grant of the patent: **12.03.1997**
(21) Application number: 91916606.6
(22) Date of filing: 19.09.1991
(51) Int. Cl.: G06F 11/26

(54) **SEMICONDUCTOR INTEGRATED CIRCUIT DEVICE WITH TESTING-CONTROLLING CIRCUIT PROVIDED IN INPUT/OUTPUT REGION**
INTEGRIERTE HALBLEITER-SCHALTUNG MIT PRÜF-STEUERSCHALTUNG IN EINEM E/A-BEREICH
DISPOSITIF A CIRCUIT INTEGRE A SEMI-CONDUCTEUR DOTE D'UN CIRCUIT DE TEST-COMMANDE AMENAGE DANS UNE REGION D'ENTREE/SORTIE

(30) Priority: 20.09.1990 JP 252526/90
(43) Date of publication of application: 09.09.1992
(73) Proprietor: FUJITSU LIMITED, Kawasaki-shi, Kanagawa 211 (JP)
(72) Inventor: YAMAMURA, Takeshi, c/o Fujitsu Limited, Kawasaki-shi, Kanagawa 211 (JP)
(74) Representative: Seeger, Wolfgang, Dipl.-Phys.
(86) International application number: JP9101243
(87) International publication number: WO9205453

(56) References cited:
- EP-A- 0 255 449
- JP-A-60 103 632
- JP-A-63 260 145
- PATENT ABSTRACTS OF JAPAN vol. 11, no. 5 (P-533)(2452) 8 January 1987 & JP-A-61 182 139
- PATENT ABSTRACTS OF JAPAN vol. 7, no. 182 (E-192)(1327) 11 August 1983 & JP-A-58 085 544

## Description

The present invention relates to a semiconductor integrated circuit device, and more specifically, to a semiconductor integrated circuit device equipped with test control circuits for testing functions of an internal circuit in a semiconductor integrated circuit.

With the recent trend for higher integration of semiconductor integrated circuit devices, various methods of examining an internal circuit have been in use. These include,
1. Internal scan method
2. Boundary scan method
3. Internal memory direct access method

In an internal scan method, a flip-flop (hereinafter called an FF) is connected to a signal path called a scan chain, which is different from a path for use in normal operation and into which a control signal is input serially so as to set a data in the FF, and a clock is output to the FF for data transfer so that the content of the FF only is read, thereby improving a failure detection rate, in consideration of the fact that if, on ther other hand, a signal path for use in normal operation is used to detect an error in the FF, a control of a test signal is troublesome since, inevitably, the test signal passes through a logic unit either in setting a data in the FF or in reading a data set in the FF.

In a boundary scan method, FFs, placed in an I/O area and capable of accepting data from outside and of outputting data to the outside, are connected via a signal path called a boundary chain, so that data can be output serially in response to an input signal, thus enabling the reading of the contents of the chain of FFs. With this method, a pair of semiconductor integrated circuit devices, for example, can be configured such that the terminals of those semiconductor integrated circuit devices are connected, and data in an FF of one of the devices is transferred to an FF of another device, so that a check is made into whether the wiring between the two semiconductor integrated circuit devices is secure.

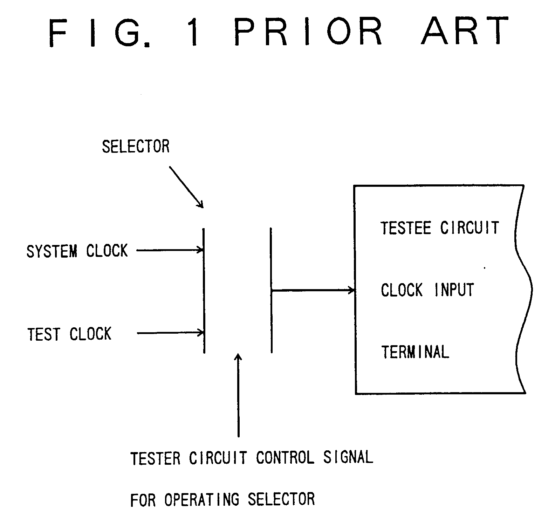

In an internal memory direct access method, a direct read/write operation of data is performed on a RAM in order to test the RAM operation: because, if a signal path for use in normal operation is used in testing a RAM in a semiconductor circuit device, a read/write operation is inevitably conducted via a logic unit, making it difficult to provide a specific test signal since providing the test signal that way must allow for a logical conversion at a logic unit. In the methods described above, clocks and data are delivered to the testee circuit via a path different from the ones used for normal operation, thereby necessitating provision of a selector for switching between the paths as shown in FIG. 1, and of a test control signal for operating this selector.

In a semiconductor integrated circuit device of high integration, the number of test control signal terminals to be implemented tend to total 10 to 20 in order to conduct a test on a semiconductor integrated circuit device; further, providing a test signal via input pins of a semiconductor integrated circuit device in an unmodified configuration means a large increase of pin count in the package, and is therefore impracticable.

Accordingly, it is recommended that a decoder circuit be provided, in a semiconductor integrated circuit device, for decoding a control signal supplied by as few as four input pins and providing the signal for a semiconductor integrated circuit device.

This requires a scan clock control circuit for controlling a scan clock and a memory test clock control circuit for controlling a test clock to be used in a internal memory test.

### BACKGROUND ART

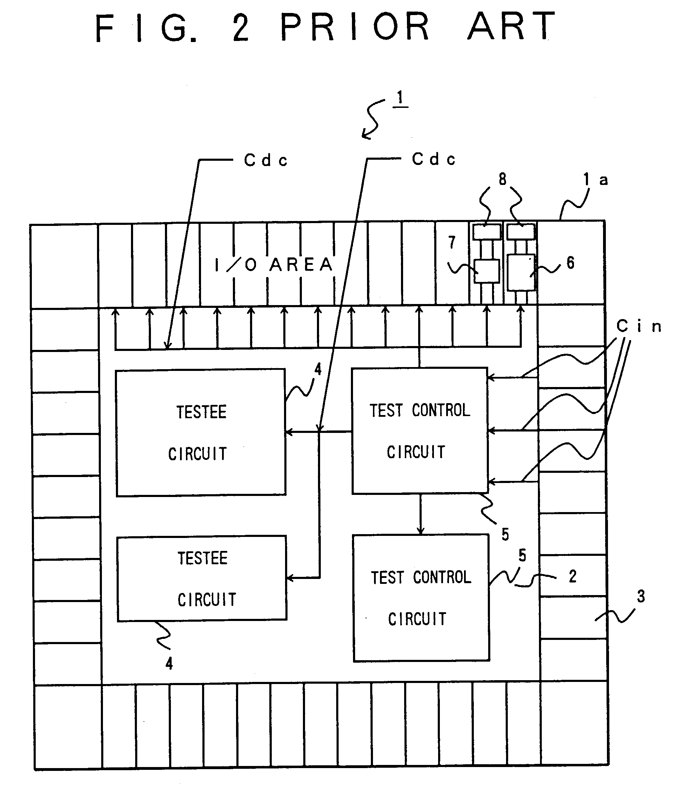

Conventional semiconductor integrated circuit devices of the type described above include the one shown in FIG. 2.

The area on a chip 1a of a semiconductor integrated circuit device 1 is divided roughly into a core area 2 and an I/O area 3. On the core area 2, testee circuits 4 and test control circuits 5 are provided.

In the I/O area 3, I/O cells 6 and tester circuits 7 are provided. The I/O cells 6, being connected to a pad 8 which is an I/O terminal for connection to the outside, include a buffer amplifier for storing and amplifying a signal when outputting a signal from the testee circuit 4 in the core area 2 to the outside and when inputting a signal from outside, and further include an electrostatic destruction protection circuit called ESD for protecting from a destruction of an internal circuit due to electrostatic from outside. Cᵢₙ is an external control signal provided from outside and C_{dc} is a test control signal as decoded by the test control circuits 5.

In this configuration, when conducting a test on functions of a semiconductor integrated circuit 1, the external control signal Cᵢₙ is given from outside and the test control signal C_{dc} as decoded by the test control circuits 5, is output to the testee circuit 4 and the tester circuits 7 in the I/O area 3; various types of test including the above-described internal scan method, the boundary scan method and the internal memory direct access method are then conducted.

However, such a conventional semiconductor integrated circuit device 1 has a disadvantage: that the placing of the test control circuits 5 in the core area 2 necessitates securing an area in the core area 2 for placing the test control circuits 5 thereon, thus resulting in a larger chip size of a semiconductor integrated circuit device 1.

The conventional technology also has a disadvantage in that it causes the laying out to become complex because a layout designer must take into account a disposition of the test control circuits 5. Particularly, when a user designs the core area 2, the presence of the test control circuits 5 in the core area 2 presents a problem. Normally, a user does not need the test control circuits 5. In many cases, it is a manufacturer of the semiconductor integrated circuit device 1 who uses the test control circuits 5. Forcing the user to design the core area 2 in consideration of the unnecessary test control circuits 5 is undesirable.

Moreover, the conventional device has a disadvantage in that it has a complicated wiring structure because the external control signal Cᵢₙ must be delivered to the core area 2 via a test control signal line distributed to the tester circuits 7 in the I/O area 3, resulting in complex wiring.

### DISCLOSURE OF THE INVENTION

Accordingly, the present invention has an object of providing a semiconductor integrated circuit device in which a chip size increase is prevented, and in which device laying out is easy because a test control signal line need not be distributed in a corea area.

The object of the present invention is achieved by the features of claim 1.

### BRIEF DESCRIPTION OF THE DRAWINGS

FIG. 1 is a diagram illustrating a switching performed by a selector;
FIG. 2 is a top view illustrating an entire configuration of a conventional chip;
FIG. 3 is a diagram illustrating a principle of a semiconductor integrated circuit device of the present invention;
FIG. 4 is a top view illustrating an entire configuration of a chip of one embodiment of the present invention;
FIGs. 5A and 5B are block diagrams illustrating a decoder circuit in each of test control circuits of FIG. 4;
FIGs. 6A and 6B are block diagrams illustrating a clock control circuit in the test control circuit of FIG. 4; and
FIGs. 7A and 7B are block diagrams illustrating a configuration of an I/O cell of FIG. 4.

### BEST MODE OF CARRYING OUT THE INVENTION

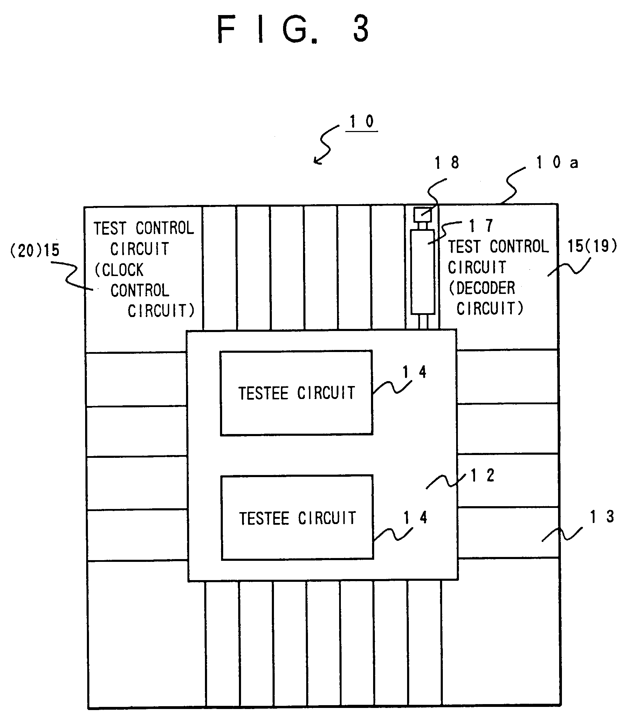

FIG. 3 is a diagram illustrating an overview of the present invention.

A semiconductor integrated circuit device 10 of the present invention is configured such that the semiconductor integrated circuit device comprises a core area 12 on a chip 10a, on which core area testee circuits 14 are placed, and an I/O area 13, on which tester circuits 17 for testing functions of the testee circuits 14 on the core area 12, are placed; and test control circuits 15, also placed in the I/O area, which test control circuits deliver, on the basis of an external control signal coming from outside, a specified control signal and a clock signal to the tester circuits 17 and the testee circuits 14.

As shown in the figure, the test control circuits 15 are placed on two separate corner portions of the chip 10a. In the upper right corner a decoder circuit 19 is placed and in the upper left corner a clock control circuit 20 is placed. That is, the test control circuits 15 are provided with the decoder circuit 19 and the clock control circuit 20.

The decoder circuit 19 decodes the external control signal coming from outside and outputs the resulting decoded signal to the tester circuits 17 and the testee circuits 14. The clock control circuit 20 outputs an external clock signal, on the basis of the control signal decoded by the decoder circuit 19, to the tester circuits 17 and the testee circuits 14. It is preferable, in conducting a test on the semiconductor integrated circuit device 10, that the configuration should be such that the test control circuits 15 output the control signal and the clock signal to the tester circuits 17 and testee circuit 14 via a signal path separate from those used for normal operation.

In the present invention the test control circuits 15 are placed in the I/O area 13 and only the testee circuits 14 having specific functions are placed in the core area 12. That is, an area in the core area for the placement of the test control circuits 15 is unnecessary , with the result that an increase is prevented in chip size of the semiconductor integrated circuit device 10; the space of the core area 12 is effectively utilized solely by the testee circuits 14 having specific functions, making the laying out easy to perform, the connection between the test control circuits 15 and the tester circuits 17 is made easy due to the fact that the test control circuits 15 and the tester circuits 17 are both placed in the I/O area 13. Although the test control circuits 15 can be placed at any portion of the I/O area 13, placing them at the corner portions of the chip 10a, as shown in FIG. 3, is preferable because of a large free area available.

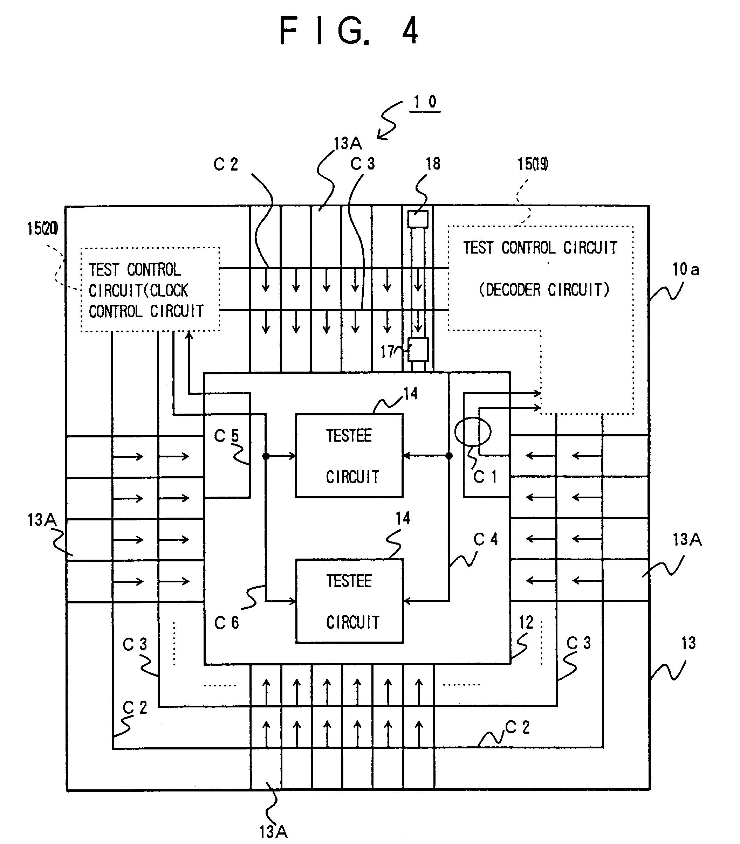

FIG. 4 is a top view of a semiconductor integrated circuit device 10 of one embodiment of the present invention. The area on the chip 10a consists of the core area 12 and the I/O area 13. In the core area the testee circuits 14 having specific functions are placed, and in two corners of the I/O area 13 the test control circuits 15 are placed. The test control circuits 15 comprise the decoder circuit 19 and the clock control circuit 20.

The decoder circuit 19 decodes an external control signal C1 coming from outside, and outputs the resulting decoded signals C2 and C4 to the tester circuits 17 and the testee circuits 14 respectively.

The clock control circuit 20 outputs, on the basis of the control signal C2 from the decoder circuit 19, an external clock signal C5 or an internally generated clock signal, to the tester circuits 17 and the testee circuits 14. In the figure, clock signals output from the clock control circuit 20 to the tester circuits 17 and the testee circuits 14 are shown as C3 and C6 respectively.

The clock control circuit 20 is equipped with either or both of the following circuits: a scan clock control circuit for controlling a scan clock to be used in the event that the aforementioned test methods, such as the internal scan method or the boundary scan method, are employed as a test method; and/or a memory test clock control circuit for controlling a test clock in the event that an internal memory direct access method is employed as a test method.

In the I/O area 13 a plurality of I/O cells 13A are arrayed. Each I/O cell 13A includes a pad 18, a tester circuit 17, and test wiring.

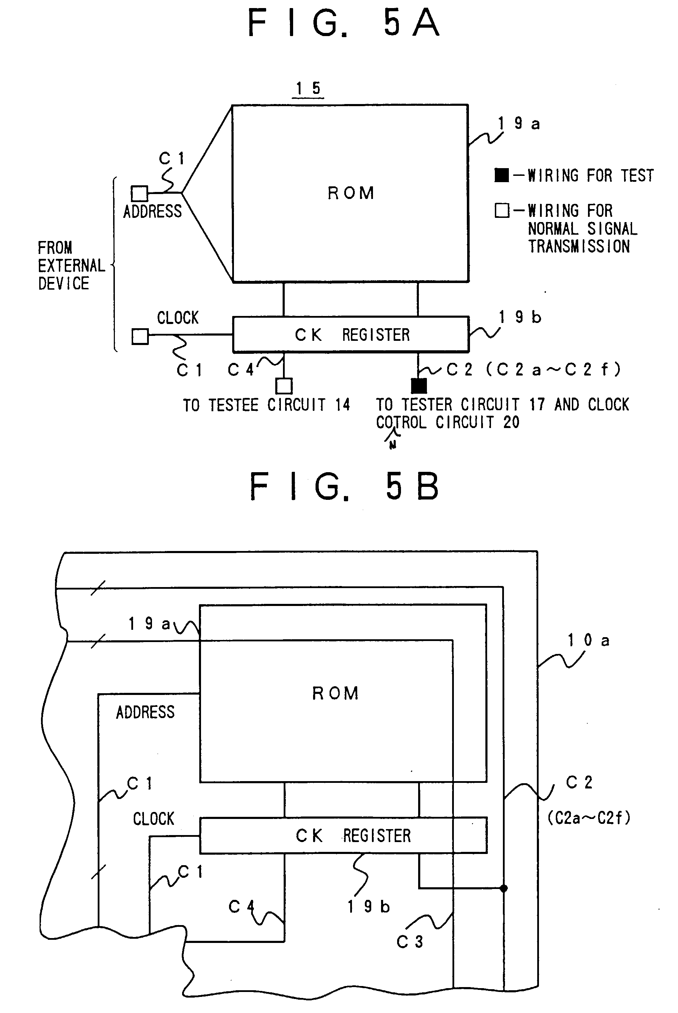

FIG. 5A is a block diagram illustrating the decoder circuit 19 of the test control circuit 15 shown in FIG. 4. The decoder circuit 19 consists of a ROM 19a into which a specified data is written, and a register 19b. The ROM 19a, via the register 19b operating in synchronization with a clock signal portion of the external control signal C1, outputs the control signal C2 that is the portion of the external control signal C1, supplied from outside the semiconductor integrated circuit device 1, which corresponds to an address signal (consisting of a plurality of bits) of the ROM 19a, to each tester circuit 17 and the clock control circuit 20, and outputs the control signal C4 to each testee circuit 14. As will be described later, the control signal C2 includes control signals C2a - C2f.

FIG. 5B is a block diagram illustrating a layout of the decoder circuit 19 shown in FIG. 5A. Near the corner of the chip 10a the ROM 19a is placed, and the register 19b is adjacent to the ROM 19a.

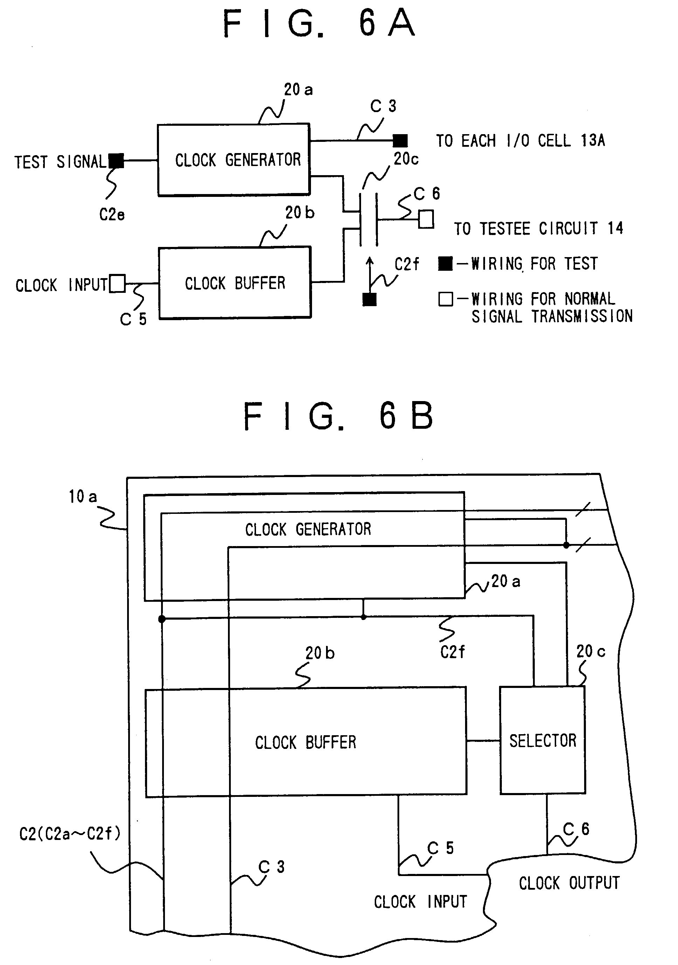

FIG. 6A is a block diagram of the clock control circuit 20 shown in FIG. 4. The clock control circuit 20 comprises a clock generator 20a, a clock buffer 20b, and a selector 20c. The clock generator 20a selectively generates various clock signals for test use, in accordance with a test control signal C2f output by the ROM 19a in FIG. 5A. The clock buffer 20b temporarily retains various external clock signals C5 and outputs them to the selector 20C. The selector 20c selects between the clock signal C3 generated by the clock generator 20a and the clock signal from the clock buffer 20b, and outputs either of the two to each testee circuit 14, in accordance with the control signal C2f output by the ROM 19a of FIG. 4A. The clock signal C3 generated by the clock generator 20a is supplied to each I/O cell 13A.

FIG. 6B is a block diagram illustrating a layout of the clock control circuit 20 shown in FIG. 6A. Near the corner of the chip 10a the clock generator 20a is placed, and the clock buffer 20b and the selector 20c are placed in the vicinity thereof, as shown in the figure.

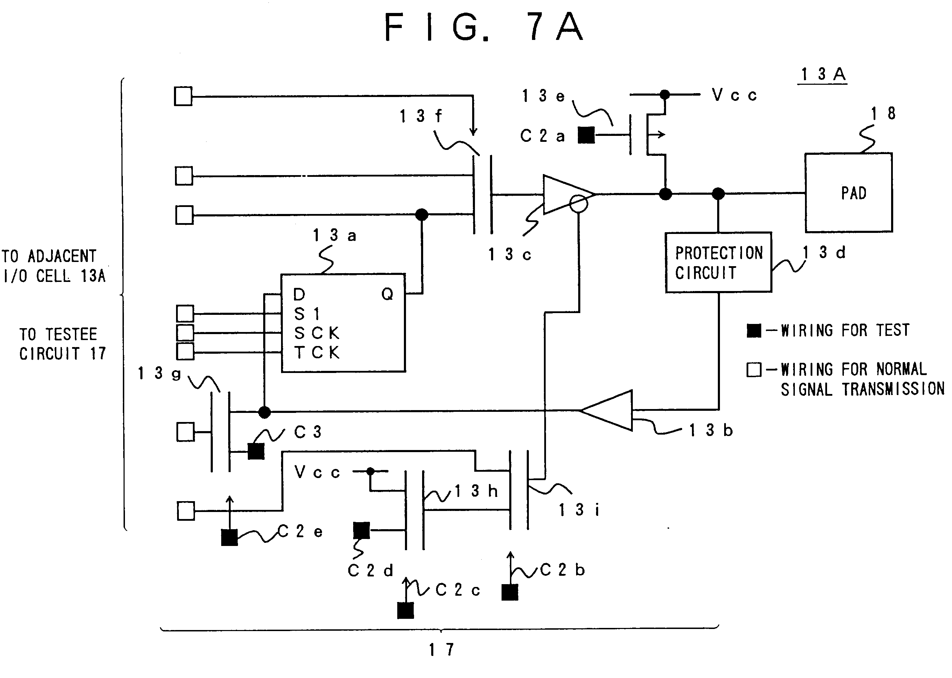

FIG. 7A is a block diagram illustrating the tester circuit 17 provided in each I/O cell 13A. The tester circuit 17 comprises a scan flip-flop (hereinafter simply called the flip-flop) 13a, an input circuit 13b, an output circuit 13c composed of tristate inverters, a protection circuit 13d, a pull-up transistor 13e, and selectors 13f - 13i. The flip-flop 13a is used in a boundary scan test in such a way that the flip-flop is synchronized with a scan clock signal provided at a SCK (scan clock) terminal while a SI (scan-in) terminal is maintained active, and the flip-flop latches a test data, from the pad 18 or the preceding I/O cell 17A, in a D (data) terminal via the selector 13f, the output circuit 13d, the protection circuit 13d, and the input circuit 13d. A test is conducted in such a way that after the test data is latched in the flip-flop 13a in each I/O cell 17A, a pulse of the test clock is provided at a TCK (test clock) terminal, and the latched data is read sequentially via a terminal Q. The SI, SCK, and TCK of each I/O cell 17A are connected with each other, and are provided sequentially with a corresponding signal from outside.

The selector 13g selectively outputs a signal from the input circuit 13b or the clock signal C3 generated by the clock generator 20a of FIG. 6A to the testee circuit 17, in accordance with the control signal C2e output by the ROM 19a of FIG. 5A. The selector 13h selects either the control signal C2d output by the ROM 19a in order to control the status of the output circuit 13c, or a power supply voltage Vcc, in accordance with the control signal C2e from the ROM 19a of FIG. 5A, and outputs the selected one of the signal or the power supply voltage Vcc to the selector 13i. The selector 13i selects, on the basis of the control signal C2b output by the ROM 19a in FIG. 5A, between a signal from the testee circuit 17A and a signal from the selector 13h, and outputs the selected signal to the output circuit 13c. The pull-up transistor 13e selectively connects the pad 18 to the power supply line Vcc, in accordance with the control signal C2a from the ROM 19a.

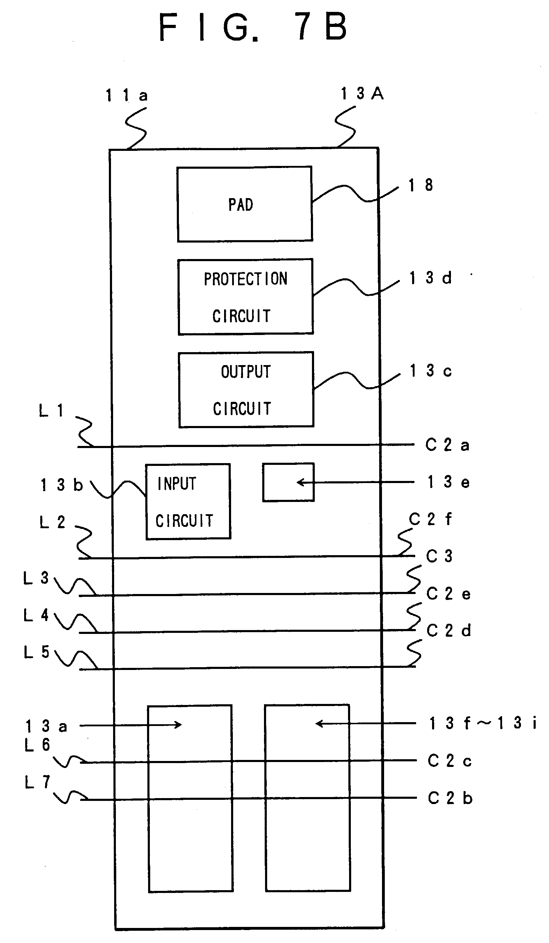

FIG. 7B is block diagram illustrating a layout of the tester circuit 17 of FIG. 7A. As shown in the figure, starting from near the periphery of the chip 10a, the pad 18, the protection circuit 13d, the output circuit 13c, the input circuit 13b, the pull-up circuit 13e, the flip-flop 13a, and the selectors 13f - 13i are arrayed. On the tester circuit 17, the wirings L1 - L7 are formed. The wiring L1 carries the control signal C2a and the wiring L2 carries the control signal C2f. The wiring L3 carries the clock signal C3 generated by the clock generator 20a of FIG. 6A, and the clock signal C3 including a scan-in signal, the scan clock signal, and a test clock signal from the clock buffer 20b. The wiring L4 carries the control signal C2e, and the wiring L5 carries the control signal C2d. The wiring L6 carries the control signal C2c, and the wiring L7 carries the control signal C2b. Each of respective components of the wirings L1 - L7 and the tester circuit 13A are connected as shown in FIG. 7A, although this is not shown in FIG. 7B.

When conducting a test to examine functions of the semiconductor integrated circuit device 10, an external control signal C1 is supplied to the decoder circuit 19 from outside to be decoded by the decoder circuit 19 into test control signals C2a - C2f, which test control signals are output to the tester circuits 17 in the I/O area 13. The test control signal C2e is output to the clock control circuit 20; the test control signal C6 is output to the testee circuit 14 in the core area 12; the test clock signal C5, which is supplied from outside to the clock control circuit 20, is output as the clock signal C3 supplied from the clock control circuit 20 to the tester circuits 17 in the I/O area 13, and as the clock signal C6 supplied to the testee circuit 14 in the core area 12, permitting the conducting of various tests including the above-described internal scan method, the boundary method, or the internal memory direct access method. Thus, in case a test method is employed where a scan chain is formed, a scan chain is formed within the I/O area 3 alone.

Thus, the present invention eliminates the need of a space in the core area 12 for the test control circuits 15, thus permitting an effective utilization of the space in the core area 12 solely by the testee circuits 14 having specific functions, further permitting the placement of both the test control circuits 15 and the tester circuits 17 in the I/O area 13 so that an increase in chip size of the semiconductor integrated circuit device 10 is prevented, and further resulting in easy-to-do lay out, and easy connection between the test control circuits 15 and the tester circuits 17.

Consequently, a semiconductor integrated circuit device can be configured such that an increase in chip size is prevented, the laying out is easy to do, and the test control signal lines need not be distributed in the core area 12.

Moreover, the placement of both the test control circuits 15 and the tester circuits 17 in the I/O area 13 does not require placing the test control circuits 15, which are unnecessary for the user, in the core area 12 which may be wanted for selef-design by the use: therefore the use of the test control circuits 15 need not be exposed to the user.

While the above-mentioned embodiment was explained by using an example case where the test control circuits 15 are placed at the corner of the I/O area 13, the test control circuits 15 can also be placed at other portions of the I/O area 13, if it is allowable to sacrifice low pin count in the I/O area 13.

### POSSIBLE APPLICATION IN INDUSTRY

The present invention makes it unnecessary to provide a space for the test control circuits in the core area, and prevents an increase in chip size of the semiconductor integrated circuit device.

The core area is effectively utilized solely by the testee circuits having specific functions, making the lay out easy to perform. Both the test control circuits and the tester circuits are placed in the I/O area so that the connection between the test control circuits and the tester circuits is easy.

Accordingly, an increase in chip size is prevented, while permitting the provision of a semiconductor device in which the lay out is easy to perform and the distribution of the test control signal lines in the core area is not required.

## Claims

1. A semiconductor integrated circuit device comprising:
a chip;
a core area on said chip on which testee circuits having specific functions are placed; and
an I/O area on said chip, which I/O area is located at the periphery of said core area, and on which I/O area are placed a plurality of tester circuits for testing the functions of said testee circuits in said core area,
said semiconductor integrated circuit device being characterized in that:
said I/O area is further equipped with test control circuits, which test control circuits supply control signals and a clock signal, for testing said testee circuits, to said tester circuits and testee circuits, on the basis of an external signal coming from outside.

2. A semiconductor integrated circuit device as claimed in claim 1, wherein:
each of said test control circuits comprises:
decoding means for decoding said external control signal and generating a control signal as a result of decoding; and
clock control means for outputting said clock signal on the basis of the portion of said control signal generated by said decoding means that corresponds to said outputting.

3. A semiconductor integrated circuit device as claimed in claim 2, wherein said decoding means is placed near a first corner of said chip and said clock control means is placed near a second corner of said chip.

4. A semiconductor integrated circuit device as claimed in claim 1, wherein said I/O area comprises wirings for transmitting said control signal and said clock signal.

5. A semiconductor integrated circuit device as claimed in claim 1, wherein:
said semiconductor integrated circuit device comprises a plurality of I/O cells provided in said I/O area; and
each of said I/O cells comprises one of said plurality of tester circuits, a pad, and an interface circuit connecting each of said testee circuits to said pad.

6. A semiconductor integrated circuit device as claimed in claim 2, wherein:
said decoding means comprises a ROM for storing said control signal; and
said external control signal is an address signal of said ROM.

7. A semiconductor integrated circuit device as claimed in claim 2, wherein said clock control means comprises clock generation means for generating a specified test clock signal in accordance with said corresponding control signal.

8. A semiconductor integrated circuit device as claimed in claim 2, wherein said clock control means comprises buffer means for outputting an external clock signal supplied from outside to each of said tester circuits.

9. A semiconductor integrated circuit device as claimed in claim 7, wherein said clock control means comprises selection means for selectively outputting, to each of said testee circuits, either the external clock signal supplied from outside or said test clock signal.

10. A semiconductor integrated circuit device as claimed in claim 9, wherein said selection means is controlled by one of said control signals corresponding to said selection means.

11. A semiconductor integrated circuit device as claimed in claim 5, wherein each of said I/O cells comprises a flip-flop for test use, each flip-flop being connected to each other in a chain-like manner.

12. A semiconductor integrated circuit device as claimed in claim 5, wherein each of said I/O cell interfaces comprises a tristate buffer; and
each of said I/O cells comprise controlling means for controlling said tristate buffer on the basis of one of said control signals that corresponds to said controlling.

13. A semiconductor integrated circuit device as claimed in claim 5, wherein each of said I/O cells comprises a pull-up transistor; and
each said pull-up transistor setting said pad at specified power supply voltage on the basis of one of said control signals that corresponds to said setting.

14. A semiconductor integrated circuit device as claimed in claim 5, wherein each of said I/O cells outputs either a signal from said interface circuit or said clock signal to each of said testee circuits on the basis of one of said control signals that corresponds to said outputting.

## Patentansprüche

1. Integrierte Halbleiterschaltungsvorrichtung, mit:
einem Chip;
einem Kernbereich auf dem Chip, auf dem zu testende Schaltungen mit spezifischen Funktionen plaziert sind; und
einem I/O-Bereich auf dem Chip, wobei der I/O-Bereich an der Peripherie des Kernbereiches gelegen ist und auf dem I/O-Bereich eine Vielzahl von Tester-Schaltungen zum Testen der Funktionen der zu testenden Schaltungen in dem Kernbereich plaziert sind,
wobei die integrierte Halbleiterschaltungsvorrichtung dadurch **gekennzeichnet** ist, daß
der I/O-Bereich ferner mit Teststeuerschaltungen ausgestattet ist, welche Teststeuerschaltungen Steuersignale und ein Taktsignal zum Testen der zu testenden Schaltungen den Tester-Schaltungen und den zu testenden Schaltungen auf der Grundlage eines von außerhalb kommenden externen Signales zuführen.

2. Integrierte Halbleiterschaltungsvorrichtung nach Anspruch 1, bei der
jede der Teststeuerschaltungen folgendes umfaßt:
eine Dekodiereinrichtung zum Dekodieren des externen Steuersignals und zum Erzeugen eines Steuersignals als Ergebnis der Dekodierung; und
eine Taktsteuereinrichtung für die Ausgabe des Taktsignals auf der Grundlage des Abschnitts des durch die Dekodiereinrichtung erzeugten Steuersignals, welcher Abschnitt der Ausgabegröße entspricht.

3. Integrierte Halbleiterschaltungsvorrichtung nach Anspruch 2, bei der die Dekodiereinrichtung nahe einer ersten Ecke des Chips plaziert ist und die Taktsteuereinrichtung nahe einer zweiten Ecke des Chips plaziert ist.

4. Integrierte Halbleiterschaltungsvorrichtung nach Anspruch 1, bei der der I/O-Bereich Verdrahtungen enthält, um das Steuersignal und das Taktsignal zu übertragen.

5. Integrierte Halbleiterschaltungsvorrichtung nach Anspruch 1, bei der
die integrierte Halbleiterschaltungsvorrichtung eine Vielzahl von I/O-Zellen umfaßt, die in dem I/O-Bereich vorgesehen sind, und
jede der I/O-Zellen eine der Vielzahl der Tester-Schaltungen, eine Anschlußfläche und eine Interface-Schaltung umfaßt, die jede der zu testenden Schaltungen mit der Anschlußfläche verbindet.

6. Integrierte Halbleiterschaltungsvorrichtung nach Anspruch 2, bei der
die Dekodiereinrichtung einen ROM zum Speichern des Steuersignals enthält; und
das externe Steuersignal ein Adreßsignal des ROM's darstellt.

7. Integrierte Halbleiterschaltungsvorrichtung nach Anspruch 2, bei der die Taktsteuereinrichtung eine Taktgeneratoreinrichtung umfaßt, um ein spezifiziertes Testtaktsignal in Einklang mit dem entsprechenden Steuersignal zu erzeugen.

8. Integrierte Halbleiterschaltungsvorrichtung nach Anspruch 2, bei der die Taktsteuereinrichtung eine Puffereinrichtung umfaßt, um ein externes Taktsignal, welches von außerhalb zugeführt wird, an jede der Tester-Schaltungen auszugeben.

9. Integrierte Halbleiterschaltungsvorrichtung nach Anspruch 7, bei der die Taktsteuereinrichtung eine Wähleinrichtung umfaßt, um selektiv an jede der zu testenden Schaltungen entweder das externe Taktsignal, welches von außerhalb zugeführt wurde, oder das Testtaktsignal auszugeben.

10. Integrierte Halbleiterschaltungsvorrichtung nach Anspruch 9, bei der die Wähleinrichtung durch eines der Steuersignale, welches der Wähleinrichtung entspricht, steuerbar ist.

11. Integrierte Halbleiterschaltungsvorrichtung nach Anspruch 5, bei der jede der I/O-Zellen einen Flipflop für die Verwendung beim Test umfaßt, wobei jeder Flipflop mit jedem anderen Flipflop in einer kettenförmigen Weise verbunden ist.

12. Integrierte Halbleiterschaltungsvorrichtung nach Anspruch 5, bei der jedes I/O-Zellen-Interface einen Puffer mit drei Zuständen aufweist; und
jede der I/O-Zellen eine Steuereinrichtung aufweist, um den Puffer mit drei Zuständen auf der Grundlage von einem der Steuersignale, welches der Steuereinrichtung entspricht, zu steuern.

13. Integrierte Halbleiterschaltungsvorrichtung nach Anspruch 5, bei der jede I/O-Zelle einen Hochzieh-Transistor aufweist; und
jeder Hochzieh-Transistor die Anschlußfläche mit einer spezifischen Stromversorgungsspannung auf der Grundlage von einem der Steuersignale, welches dieser Einstellung entspricht, versieht.

14. Integrierte Halbleiterschaltungsvorrichtung nach Anspruch 5, bei der jede I/O-Zelle entweder ein Signal von der Interface-Schaltung oder ein Taktsignal zu jeder der zu testenden Schaltungen auf der Grundlage von einem der Steuersignale, welches der Ausgabegröße entspricht, ausgibt.

## Revendications

1. Dispositif à circuit intégré à semiconducteur comportant:
une puce;
une zone de coeur sur ladite puce sur laquelle sont placés les circuits à tester à fonctions spécifiques; et
une zone d'entrée/sortie I/O sur ladite puce, zone I/O qui est située à la périphérie de ladite zone de coeur et zone I/O sur laquelle sont placés une pluralité de circuits de test pour tester les fonctions desdits circuits à tester placés dans ladite zone de coeur,
ledit dispositif à circuit intégré à semiconducteur étant caractérisé par le fait que;
ladite zone d'entrée/sortie I/O est en outre équipée de circuits de contrôle de test, circuits de contrôle de test qui, sur la base d' un signal extérieur provenant de l'extérieur, fournissent, auxdits circuits de test et auxdits circuits à tester, un signal de commande et un signal d' horloge pour tester lesdits circuits à tester.

2. Dispositif à circuit intégré à semiconducteur comme revendiqué dans la revendication 1, dans lequel:
chacun desdits circuits de commande de test comporte:
des moyens de décodage pour décoder ledit signal de commande extérieur et générer un signal de commande comme résultat du décodage; et
des moyens de commande de signal d'horloge pour émettre ledit signal d'horloge sur la base de la portion dudit signal de commande généré par lesdits moyens de décodage qui correspond à ladite émission.

3. Dispositif à circuit intégré à semiconducteur comme revendiqué dans la revendication 2, dans lequel lesdits moyens de décodage sont placés près d' un premier angle de ladite puce et dans lequel lesdits moyens de commande de signal d'horloge sont placés près d'un second angle de ladite puce.

4. Dispositif à circuit intégré à semiconducteur comme revendiqué dans la revendication 1, dans lequel ladite zone d'entrée/sortie I/O comporte des câblages pour transmettre ledit signal de commande et ledit signal d' horloge.

5. Dispositif à circuit intégré à semiconducteur comme revendiqué dans la revendication 1, dans lequel:
ledit dispositif à circuit intégré à semiconducteur comporte une pluralité de cellules d'entrée/sortie I/O prévues dans ladite zone d'entrée/sortie I/O; et
chacune desdites cellules d'entrée/sortie I/O comporte l'un d'une dite pluralité de circuits de test, une plage de connexion, et un circuit d'interface reliant chacun desdits circuits à tester à ladite plage de connexion.

6. Dispositif à circuit intégré à semiconducteur comme revendiqué dans la revendication 2, dans lequel:
lesdits moyens de décodage comportent une mémoire morte ROM pour mémoriser ledit signal de commande; et
ledit signal de commande extérieur est un signal d'adresse de ladite mémoire ROM.

7. Dispositif à circuit intégré à semiconducteur comme revendiqué dans la revendication 2, dans lequel lesdits moyens de commande de signal d'horloge comportent des moyens de génération de signal d'horloge pour générer un signal d'horloge du test spécifié, en accord avec ledit signal de commande correspondant.

8. Dispositif à circuit intégré à semiconducteur comme revendiqué dans la revendication 2, dans lequel lesdits moyens de commande de signal d'horloge comportent des moyen de mémoire tampon pour envoyer à chacun desdits circuits de test un signal d' horloge extérieur provenant de l'extérieur.

9. Dispositif à circuit intégré à semiconducteur comme revendiqué dans la revendication 7, dans lequel lesdits moyens de commande de signal d'horloge comportent des moyens de sélection pour envoyer sélectivement, à chacun desdits circuits à tester, soit le signal d'horloge extérieur provenant de l'extérieur soit ledit signal d'horloge de test.

10. Dispositif à circuit intégré à semiconducteur comme revendiqué dans la revendication 9, dans lequel lesdits moyens de sélection sont commandés par l'un desdits signaux de commande correspondant auxdits moyens de sélection.

11. Dispositif à circuit intégré à semiconducteur comme revendiqué dans la revendication 5, dans lequel chacune desdites cellules d' entrée/sortie I/O comporte une bascule à employer pour le test, chaque bascule étant reliée les unes aux autres à la façon d'une chaîne.

12. Dispositif à circuit intégré à semiconducteur comme revendiqué dans la revendication 5, dans lequel chacune desdites interfaces de cellule d'entrée/sortie I/O comporte une mémoire tampon à trois états; et
chacune desdites cellules d'entrée/sortie I/O comporte des moyens de commande pour commander ladite mémoire tampon à trois états sur la base de l'un desdits signaux de commande qui correspond à ladite commande.

13. Dispositif à circuit intégré à semiconducteur comme revendiqué dans la revendication 5, dans lequel chacune desdites cellules d'entrée/sortie I/O comporte un transistor d'excursion haute; et
chaque dit transistor d'excursion haute plaçant ladite plage de connexion à la tension d'alimentation puissance spécifiée sur la base de l'un desdits signaux de commande qui correspond audit placement.

14. Dispositif à circuit intégré à semiconducteur comme revendiqué dans la revendication 5, dans lequel chacune desdites cellules d' entrée/sortie I/O envoie à chacun desdits circuits à tester, sur la base de l'un desdits signaux de commande qui correspond audit envoi, soit un signal provenant dudit circuit d'interface soit ledit signal d' horloge.
